Europäisches Patentamt

European Patent Office

Office européen des brevets

(19)

(11) Numéro de publication: **0 231 690 B1**

(12) **FASCICULE DE BREVET EUROPEEN**

(45) Date de publication du fascicule du brevet:
03.10.90

(51) Int. Cl.⁵: **H03G 3/20**, G01V 1/24

(21) Numéro de dépôt: **86402797.4**

(22) Date de dépôt: **12.12.86**

(54) Dispositif pour l'amplification et l'échantillonnage de signaux analogiques multiplexes.

(30) Priorité: **30.12.85  FR 8519426**

(43) Date de publication de la demande:
**12.08.87 Bulletin 87/33**

(45) Mention de la délivrance du brevet:
**03.10.90 Bulletin 90/40**

(84) Etats contractants désignés:
**BE DE GB IT NL**

(56) Documents cités:
**FR-A- 2 441 956**
**GB-A- 2 081 038**

(73) Titulaire: **INSTITUT FRANCAIS DU PETROLE, 4, Avenue de Bois-Préau, F-92502 Rueil-Malmaison(FR)**

(72) Inventeur: **Beauducel, Claude, 8, rue Talon, F-60119 Hénonville(FR)**
Inventeur: **Fouquet, Pierre, 44, rue de l'Ermitage, F-95100 Argenteuil(FR)**

ACTORUM AG

**Description**

L'invention a pour objet un dispositif pour l'amplification et l'échantillonnage de signaux ou analogiques multiplexés, notamment de signaux sismiques. Le dispositif peut être inclus dans une chaîne d'acquisition de données sismiques pour amplifier et échantillonner les signaux fournis par un ou plusieurs capteurs disposés à l'intérieur d'une flûte sismique, avant leur numérisation par un convertisseur analogique-numérique et leur enregistrement.

Suivant un procédé connu, les signaux issus d'un multiplexeur disposé en tête sont appliqués à une chaîne d'éléments amplificateurs disposés en série, le gain de chacun d'eux étant fixe. Un organe de sélection choisit le nombre d'unités d'amplification que doit traverser chaque signal compte tenu de son amplitude, pour atteindre le niveau optimal et commute la sortie de l'unité d'amplification où celui-ci est disponible, à l'entrée d'un convertisseur analogique-numérique. Les gains des différents étages peuvent être tous identiques ou bien encore tous différents les uns des autres, le gain d'un étage quelconque étant par exemple égal au carré de la valeur du gain de l'étage précédent. De telles chaînes d'amplification sont décrites par exemple dans les brevets français n, 2.110.758 ou 2.373.914.

Les amplificateurs constitués d'une cascade d'unités d'amplification comportant un multiplexeur en tête présentent de nombreux inconvénients. Ils sont relativement lents du fait que les retards apportés par les différents étages traversés par les signaux sont cumulatifs et d'autant plus grands que le gain total à leur appliquer, est important. La durée de l'étape de choix de la sortie où le signal présente le niveau optimal compatible avec le convertisseur analogique-numérique, est aussi d'autant plus grande que la chaîne est plus longue.

En outre la mémorisation des valeurs des échantillons de signaux disponibles à la sortie du multiplexeur en tête, est effectuée par un élément de mémorisation du type échantillonneur-bloquer (sample and hold unit) dont le défaut est généralement de créer de la diaphonie entre échantillons successifs ceci étant d'autant plus sensible que la dynamique des signaux qu'on leur applique est importante. Les erreurs dues à la diaphonie se produisant avant l'amplificateur, sont amplifiés par toute la chaîne d'étages d'amplification.

Par le brevet FR-A 2 441 956, on connait un système d'acquisition sismique comportant des moyens d'amplification et d'échantillonnage appliquant à chaque signal issu d'un multiplexeur plusieurs gains d'amplification fixes différentes les uns des autres, au moyen d'une pluralité d'étages d'amplification à gains fixes disposés en parallèle, des moyens de comparaison de l'amplitude des signaux amplifiés avec des tensions de référence déterminées, et des moyens de sélection du signal dont le gain est optimal. La sélection s'opère en deux étapes d'amplification successives. On procède d'abord à la numérisation du signal issu à chaque fois, systématiquement d'un même étage d'amplification puis on sélectionne l'étage qui convient pour obtenir le niveau optimal d'après la valeur numérisée du signal. Un tel système convient pour l'amplification de signaux dont la dynamique n'est pas trop grande du fait que les gains sont tous fournis par des étages à gains fixes mis en parallèle, et il requiert autant d'unités d'échantilloneurs qu'il y a d'étages d'amplification.

Le dispositif selon l'invention, tel qu'il est défini par les revendications, permet d'amplifier et d'échantillonner des signaux multiplexés à grande dynamique de manière à leur donner une amplitude optimale avant leur application à un convertisseur analogique-numérique, en évitant les inconvénients des dispositifs antérieurs.

Le dispositif selon l'invention comporte des moyens d'amplification et d'échantillonnage appliquant à chaque signal multiplexé plusieurs gains d'amplification fixes et différents les uns des autres, des moyens de comparaison de l'amplitude des signaux amplifiés avec des tensions de seuils déterminées et des moyens pour sélectionner parmi les signaux de gain d'amplification différents, celui dont le gain est optimal, et il est caractérisé en ce que les moyens d'amplification et d'échantillonnage comportent trois ensemble d'amplification et d'échantillonnage dont les gains sont respectivement égaux à 1, $b^4$ et $b^8$ où b est une valeur de gain élémentaire, un amplificateur dont le gain est susceptible de prendre sélectivement les valeurs 1, b, $b^2$ et $b^3$ par action sur des commutateurs de sélection et des éléments de connexion pour connecter sélectivement la sortie d'un des trois ensembles d'amplification et d'échantillonnage en série avec l'entre de l'amplificateur, et des moyens de sélection pour choisir une combinaison d'un commutateur de sélection et d'un élément de connexion permettant d'appliquer à chaque signal, par un seul cycle d'amplification, un gain compris entre les valeurs 1 et $b^{11}$ susceptible d'amener l'amplitude de chaque signal amplifié à une valeur optimale en relation avec les tensions de seuils déterminées.

Le dispositif selon l'invention est avantageux en ce que :
- l'échantillonnage et l'amplification sont réalisés à l'issue d'un cycle court de sélection de voies et de gains mettant en jeu un nombre restreint d'éléments dont le gain variable par paliers, atteint des valeurs très importantes, $2^{11}$,
- une partie notable (égale à 16 ou 256 par exemple) du gain nécessaire à l'amplification est obtenue au moyen d'éléments (étages d'amplification ou échantillonneurs-bloqueurs amplifiant les signaux qu'on leur applique) dont le gain est fixe, ce qui permet de limiter certaines perturbations liées à l'emploi d'interrupteurs analogiques et d'améliorer la précision, et
- le nombre d'échantillonneurs-bloqueurs requis est restreint et, du fait de leur position dans la chaîne d'amplification et d'échantillonnage, la dynamique des signaux qui leur sont appliqués, est plus réduite que dans le cas où l'on utilise un multiplexeur en tête, ce qui contribue à minimiser la diaphonie entre échantillons successifs.

D'autres caractéristiques et avantages apparaitront à la lecture de la description de modes de réalisation donnés à titre d'exemples non limitatifs, en se référant aux dessins annexés sur lesquels :

- la figure 1 représente schématiquement un premier mode de réalisation mixte où le gain d'amplification des différents ensembles d'amplification et d'échantillonnage est apporté aux signaux à la fois par un étage d'amplification et un échantillonneur-bloqueur,
- la figure 2 représente plus en détail l'agencement d'un échantillonneur-bloqueur utilisé,
- la figure 3 représente schématiquement un second mode de réalisation où le gain d'amplification des différents ensembles est apporté par des échantillonneurs-bloqueurs à gain fixe,
- la figure 4 représente schématiquement un troisième mode de réalisation où le gain d'amplification des différents ensembles est apporté uniquement par des étages d'amplification à gain fixe, et
- la figure 5 représente sous une forme arborescente le diagramme de sélection de voies et de gains, permettant d'amener tout signal d'entrée à un niveau de sortie optimal en utilisant l'un quelconque des modes de réalisation précédents.

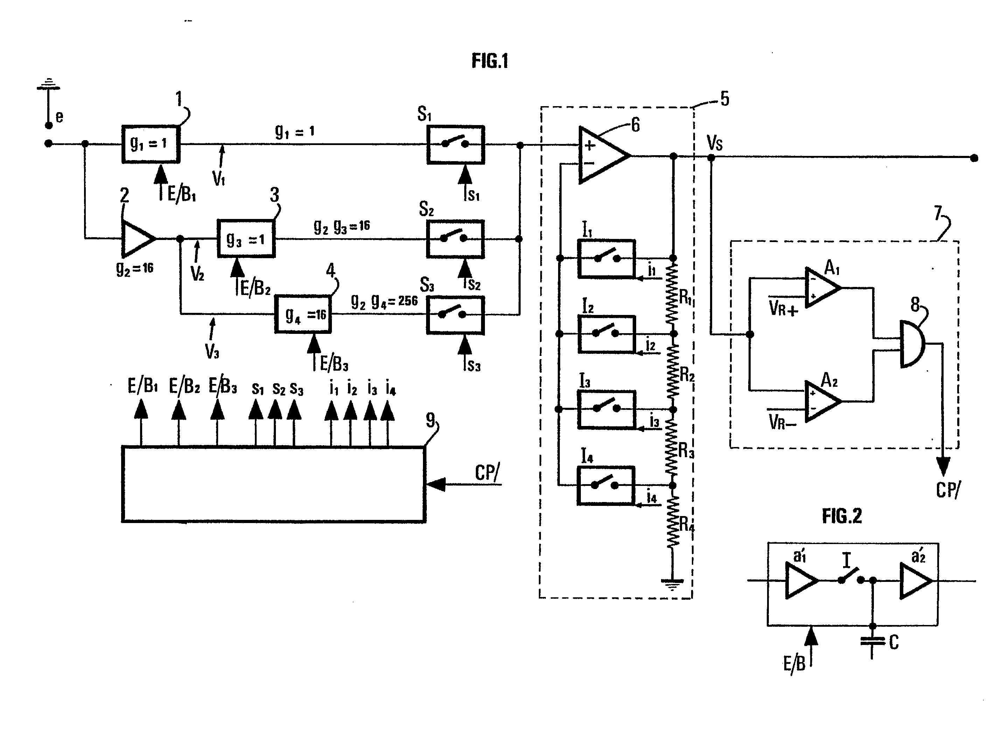

Suivant le mode préféré de réalisation représenté à la figure 1, le dispositif comporte trois ensembles d'amplification et d'échantillonnage. Le premier comporte un échantillonneur-bloqueur 1 dont le gain $g_1$ est égal à l'unité, et qui est connecté à l'entrée du dispositif. Le second compte un étage d'amplification 2 dont le gain $g_2$ est fixe et égal à 16, qui est aussi connecté à l'entrée du dispositif. La sortie de l'étage d'amplification 2 est connectée à l'entrée d'un second échantillonneur-bloqueur 3 dont le gain $g_3$ est égal à l'unité. Le troisième ensemble comporte un troisième échantillonneur-bloqueur dont le gain $g_4$ est égal à 16 et dont l'entrée est connectée à la sortie de l'étage d'amplification 2.

Les échantillonneurs-bloqueurs 1, 3, 4 utilisés sont réalisés par exemple sous la forme de circuits intégrés fabriqués par P.M.I. sous la référence SMP 11 et par National Semi Conductor sous la référence LF 198. Ces références ne sont bien entendu pas limitatives. Ces circuits échantillonneurs-bloqueurs comportent chacun (fig. 2) deux amplificateurs $a_1$ et $a_2$, interconnectés en série par l'intermédiaire d'un interrupteur I (fig. 2). Entre une première borne de l'échantillonneur-bloqueur et la masse, on connecte un condensateur de mémorisation C. Sur une seconde borne, on applique un signal de commande E/B de l'interrupteur I. Lorsque la valeur logique de ce signal est égale à 0, l'interrupteur I est fermé et la valeur de l'échantillon de signal appliqué, est chargée dans le condensateur C (phase d'échantillonnage). Un signal de valeur logique égale à 1 provoque l'ouverture de l'interrupteur I et la mémorisation de l'échantillon de signal par le condensateur C.

On désigne par E/B1, E/B2 et E/B3 respectivement, les signaux de commande des trois échantillonnements-bloqueurs 1, 3 et 4.

Les sorties des trois échantillonneurs-bloqueurs sont connectées respectivement par l'intermédiaire de trois commutateurs électroniques $S_1$, $S_2$, $S_3$ à l'entrée non inverseuse d'un second étage d'amplification 5 donc le gain est susceptible de prendre plusieurs valeurs de gain prédéterminées au moyen d'un réseau classique de contre-réaction. Ce réseau comporte quatre résistances $R_1$, $R_2$, $R_3$, $R_4$ interconnectées en série, qui relient à la masse la sortie d'un amplificateur 6. L'entrée inverseuse de l'amplificateur 6 est directement connectée à la sortie de celui-ci au travers d'un premier interrupteur $I_1$ et au point d'interconnexion des résistances $R_1$ et $R_2$ par l'intermédiaire d'un second interrupteur $I_2$. De la même façon, elle est connectée au point d'interconnexion des résistances $R_2$ et $R_3$, par l'intermédiaire d'un troisième interrupteur $I_3$ et à celui des résistances $R_3$ et $R_4$ par un quatrième interrupteur $I_4$.

Les valeurs des résistances $R_1$ à $R_4$ sont choisies de manière à donner sélectivement à l'étage d'amplification 5 un gain G égal à 1, 2, 4 cu 8 par fermeture respectivement des interrupteurs $I_1$, $I_2$, $I_3$ ou $I_4$.

Le choix du gain, permettant de donner aux signaux issus de l'étage d'amplifications, un niveau optimal est obtenu par une sélection appropriée des commutateurs $S_1$, $S_2$, $S_3$ et des interrupteurs $I_1$, $I_2$, $I_3$. Cette sélection est effectuée en fonction d'un signal CP/ issu d'un élément de comparaison 7 d'un type connu comportant par exemple, deux amplificateurs de comparaison $A_1$, $A_2$ adaptés à comparer la tension de sortie $V_S$ de l'étage d'amplification 5 avec deux tensions de référence de même valeur absolue, l'une positive $V_{R+}$, l'autre négative $V_{R-}$. Les sorties des amplificateurs de comparaison $A_1$, $A_2$ sont connectées aux entrées d'une porte OU 8. Le signal CP/M délivré par cette porte est différent selon que le signal de sortie de la chaîne est compris entre les deux tensions de référence symétriques $V_{R+}$, $V_{R-}$, ou est supérieur à $V_{R+}$ ou inférieur à $V_{R-}$. Par convention, le signal CP aura la valeur logique 0 lorsque $|V_S| \geq V_R$ et la valeur logique 1 lorsque $|V_S| < V_R$, $V_R$ étant la valeur absolue commune des tensions $V_{R+}$ et $V_{R-}$.

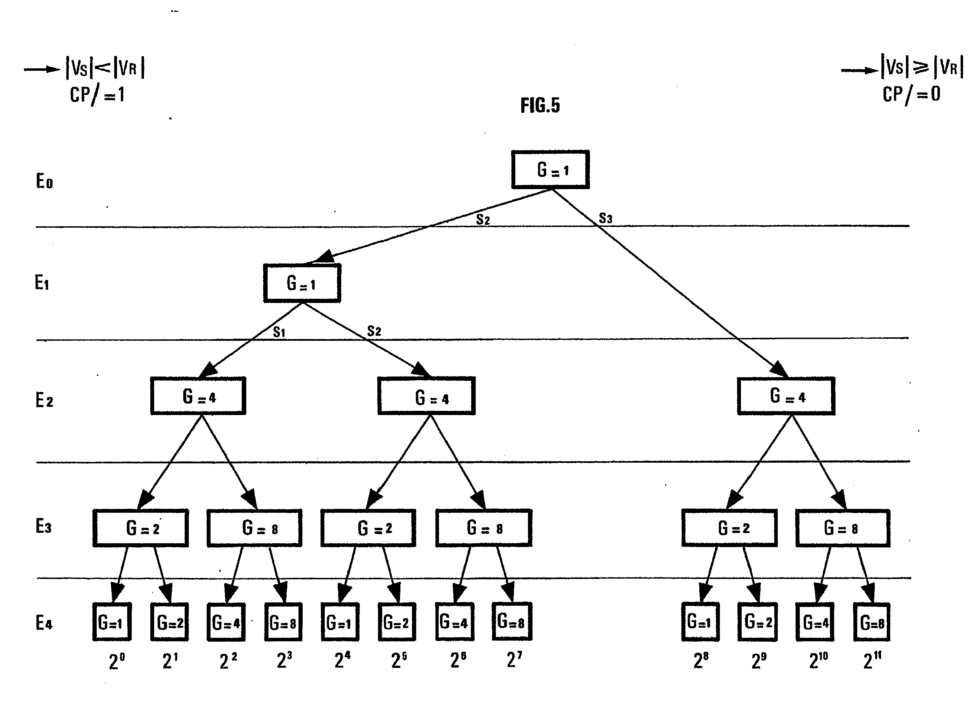

Le signal CP/ délivré par l'élément de comparaison 7 est appliqué à un ensemble de sélection 9 constitué d'éléments logiques interconnectés. Cet ensemble de sélection 9 est adapté à engendrer les signaux de commande E/B1, E/B2, E/B3 des échantillonneurs-bloqueurs 1, 3 et 4, ainsi que les signaux de commande $A_1$, $A_2$, $A_3$ des commutateurs $S_1$, $S_2$, $S_3$ et ceux ($i_1$, $i_2$, $i_3$, $i_4$) des interrupteurs $I_1$, à $I_4$, en accord avec le diagramme de sélection de la figure 5 et les ensembles d'équations logiques qui seront définis ci-après.

Chaque cycle d'amplification d'un échantillon de signal appliqué à l'entrée du dispositif comporte :
- une étape préalable $E_0$ d'échantillonnage où l'on applique à l'échantillonneur-bloqueur 1 le signal d'entrée et aux échantillonneurs-bloqueurs 3 et 4 le signal amplifié avec un gain de 16 issu de l'étage d'amplification 2.

- quatre étapes ultérieures $E_1$, $E_2$, $E_3$ et $E_4$ de mémorisation et d'application sélective de l'une des tensions mémorisées à l'étage d'amplification 5. Au cours de ces quatre étapes, on choisit le gain à appliquer à cet étage et l'on sélectionne les commutateurs appropriés $S_1$, $S_2$ ou $S_3$ pour obtenir une tension de sortie optimale compatible avec le niveau maximal requis par les éléments situés en aval (convertisseur analogique-numérique par exemple).

Dans la suite de la description, on désignera le signal de commande d'un quelconque commutateur S ($S_1$ à $S_3$) ou interrupteur I ($I_1$ à $I_4$) par : s ou i muni de la référence numérique appropriée. Lorsque ce signal aura la valeur logique 1, le commutateur ou interrupteur qu'il commande sera fermé. Inversement, la valeur logique 0 correspondra à son ouverture. On rappelle que, par convention, CP/ = 1 signifie que $|V_S| < V_R$ et que CP/ = 0 signifie que $|V_S| \cong V_R$.

L'objectif étant de donner au signal échantillonné le degré d'amplification permettant de l'amener à une tension comprise dans un intervalle choisi à l'avance ($V_{R-}$ à $V_{R+}$), le traitement des échantillons se fera par étapes successives, comme suit :

Etape $E_O$ (cf. figure 5)

L'ensemble de sélection applique aux échantillonneurs-bloqueurs 1, 3, 4 des signaux E/B1, E/B2, E/B3 de niveau logique 0 permettant la fermeture de l'interrupteur I de chacun d'eux (fig. 2), il ferme le commutateur $S_3$ et mémorise la valeur CP/0 prise par le signal de comparaison au cours de l'étape $E_0$.

Les équations logiques suivantes résument celle-ci :

$$\begin{cases} E/B1 = E/B2 = E/B3 = 0 \\ \\ s_1 = s_2 \qquad i_1 = 1 \ (G = 1) \\ s_3 = 1 \qquad i_2 = i_3 = i_4 = 0 \\ \\ CP/ \longrightarrow CP/0 \end{cases}$$

## Etape $E_1$

L'ensemble de sélection 9 applique des signaux E/B1, E/B2 et E/B3 de niveau logique 1, de manière à ouvrir les interrupteurs I des échantillonneurs-bloqueurs 1, 2, 4 et mémoriser les amplitudes des échantillons dans les condensateurs C (fig. 2). L'interrupteur $I_1$ est maintenu fermé pour conserver à l'étage amplificateur 5 un gain égal à l'unité. Le commutateur $S_1$ est maintenu ouvert. L'état des commutateurs $S_2$ et $S_3$ dépend de la valeur CP/0 mémorisée au cours de l'étape précédente et du conjugué CP/0 de cette valeur. La nouvelle valeur CP/1 prise par le signal de comparaison au cours de l'étape E1 est mémorisée.

L'étape $E_1$ est résumée par les équations logiques suivantes :

$$\begin{cases} E/B1 = E/B2 = E/B3 = 1 \\ \\ s_1 = 0 \qquad i_1 = 1 \ (G = 1) \\ s_2 = \overline{CP/0} \qquad i_2 = i_3 = i_4 = 0 \\ s_3 = CP/0 \\ \\ CP/ \longrightarrow CP/1 \end{cases}$$

## Etape $E_2$

Les échantillonneurs-bloqueurs sont maintenus en position de blocage. La position des trois commutateurs $S_1$, $S_2$, $S_3$ dépend des valeurs CP/0 et CP/1 prises par le signal de comparaison au cours des deux étapes précédentes et de leurs conjuguées CP/0 et CP/1. L'interrupteur $I_3$ est fermé, de manière à donner à l'étage 5 un gain égal à 4. La valeur CP/2 prise par le signal de comparaison est aussi mémorisée.

On aboutit aux équations logiques suivantes pour cette étape :

$$
\begin{cases}
\text{E/B1} = \text{E/B2} = \text{E/B3} = 1 \\[1em]
s_1 = \overline{\text{CP}/0} \cdot \text{CP}/1 \qquad i_3 = 1 \ (G = 4) \\
s_2 = \overline{\text{CP}/0} \cdot \text{CP}/1 \qquad i_1 = i_2 = i_4 = 0 \\
s_3 = \text{CP}/0 \\[1em]
\qquad\qquad \text{CP}/ \longrightarrow \text{CP}/2
\end{cases}
$$

## Etape $E_3$

Les échantillonneurs-bloqueurs sont toujours en position de mémorisation. On conserve les commutateurs $S_1$ à $S_3$ dans leur état précédent et l'on ferme l'interrupteur $I_3$ ou $I_4$ pour donner à l'étage d'amplification 5 un gain de 4 ou 8 selon la valeur du signal de comparaison CP/2 et de son conjugué mémorisées à la fin de l'étape $E_2$. La nouvelle valeur CP/3 de ce signal est mémorisée.

Les sélections opérées sont résumées par les équations logiques suivantes :

$$
\begin{cases}
\text{E/B1} = \text{E/B2} = \text{E/B3} = 1 \\[1em]
s_1 = \overline{\text{CP}/0} \cdot \overline{\text{CP}/1} \qquad i_1 = i2 = 0 \\
s_2 = \overline{\text{CP}/0} \cdot \text{CP}/1 \qquad i_3 = \text{CP}/2 \ (G = 8) \\
s_3 = \text{CP}/0 \qquad\qquad i_4 = \text{CP}/2 \ (G = 2)
\end{cases}
$$

## Etape $E_4$

Les échantillonneurs-bloqueurs sont maintenus dans le même état de blocage. L'état des commutateurs $S_1$, $S_2$, $S_3$ n'est pas modifié. On donne à l'étage d'amplificateur 5 un gain égal à 1, 2, 4 ou 8 suivant les valeurs logiques du signal de comparaison et de son conjugué mémorisées à la fin de deux étapes précédentes.

L'étape $E_4$ se résume par les équations logiques suivantes :

$$
\begin{cases}
\text{E/B1} = \text{E/B2} = \text{E/B3} = 1 \\[1em]
s_1 = \overline{\text{CP}/0} \cdot \overline{\text{CP}/1} \qquad i_1 = \overline{\text{CP}/2} \cdot \overline{\text{CP}/3} \ (G = 1) \\
s_2 = \overline{\text{CP}/0} \cdot \text{CP}/1 \qquad i_2 = \overline{\text{CP}/2} \cdot \text{CP}/3 \ (G = 2) \\
s_3 = \text{CP}/0 \qquad\qquad i_3 = \text{CP}/2 \cdot \overline{\text{CP}/3} \ (G = 4) \\
\qquad\qquad\qquad\qquad\quad i_4 = \text{CP}/2 \cdot \text{CP}/3 \ (G = 8)
\end{cases}
$$

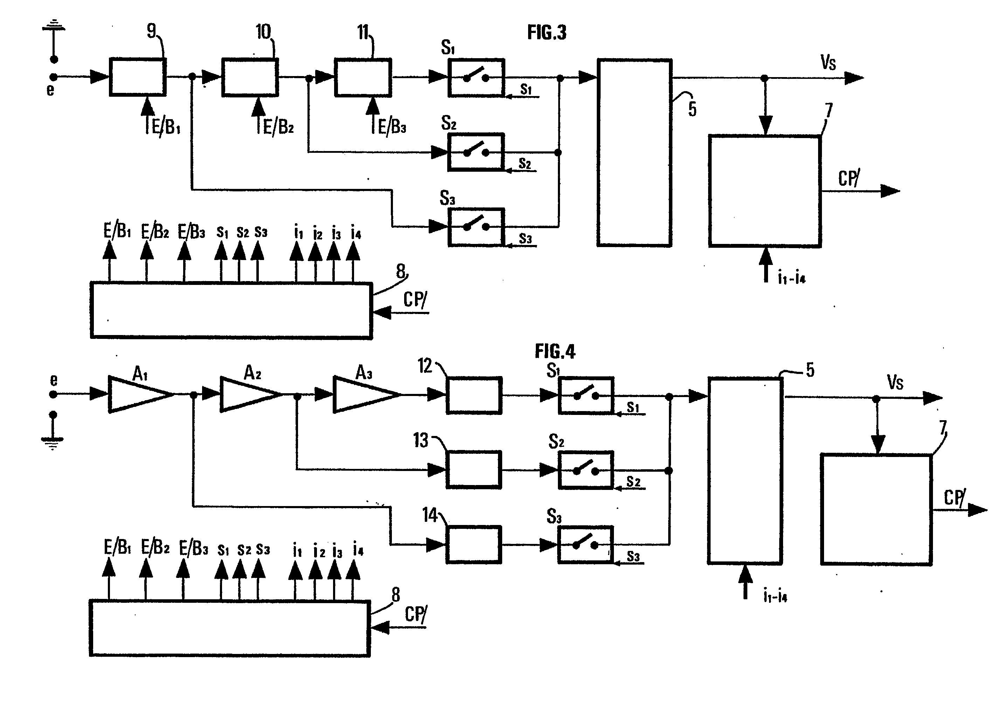

On voit sur le diagramme de sélection de la figure 3 que la suite précédente d'étapes de comparaison et de commutations successives, permet d'appliquer rapidement au signal d'entrée un gain variant par puissances successives de 2 depuis $2^0$ jusqu'à $2^{11}$ et choisi pour que l'amplitude du signal amplifié soit comprise dans la fourchette des valeurs imposées par les tensions de références $V_{R+}$ ou $V_{R-}$.

L'ensemble de sélection est entièrement défini par les différentes séquences d'équations logiques ci-dessus et par le diagramme de sélection de la figure 5. L'agencement d'éléments logiques qui permet d'effectuer ces séquences, peut donc être retrouvé sans difficulté par les spécialistes.

Dans le mode de réalisation mixte de la figure 3 l'amplification à gain fixe des signaux d'entrée, est effectuée par un étage d'amplification 2 et par un échantillonneur-bloqueur 4 appliquant un gain égal à 16 aux signaux issus dudit étage.

On ne sortirait pas du cadre de l'invention en utilisant les deux variantes représentées aux figures 3 et 4 portant sur les moyens d'échantillonnage et d'amplification à gain fixe des signaux d'entrée.

Suivant la variante de la figure 3, l'amplification et l'échantillonnage sont réalisés uniquement par des échantillonneurs-bloqueurs. Les signaux d'entrée sont appliqués à trois échantillonneurs-bloqueurs 9, 10, 11 interconnectés en série, la sortie de l'un étant connectée à l'entrée du suivant. Le premier (9) applique aux signaux un gain unité. Les deux suivants (10, 11) ont chacun un gain égal à 16. De cette manière on dispose aux sorties des trois échantillonneurs-bloqueurs de trois signaux amplifiés respectivement avec des gains égaux à 1,16 et 256.

Les sorties des trois échantillonneurs-bloqueurs sont connectées à l'entrée de l'étage amplificateur 5 à gain variable par l'intermédiaire des trois commutateurs $S_1$, $S_2$, $S_3$. Les éléments 5, 7, 8 sont identiques aux éléments correspondant du premier mode de réalisation et le cycle d'amplification et d'échantillonnage est le même que précédemment.

Suivant la variante et la figure 4, l'amplification est réalisée entièrement par des étages d'amplification, les échantillonneurs-bloqueurs utilisés ayant un gain égal à l'unité. Les signaux d'entrée sont appliqués à trois étages d'amplification $A_3$, $A_4$, $A_5$ interconnectés en série, la sortie de l'un étant connectée à l'entrée du suivant. Le gain du premier est ($A_3$) est égal à l'unité, celui des deux suivants ($A_4$, $A_5$) est égal à 16. Les signaux disponibles à leurs sorties respectives sont appliqués aux entrées de trois échantillonneurs-bloqueurs 12, 13, 14 dont le gain est égal à 1. Les signaux échantillonnés sont appliqués à l'entrée de l'étage d'amplification 5 par l'intermédiaire des trois commutateurs S1, S2, S3. Les éléments 5, 7 et 8 sont les mêmes que précédemment. Le cycle de fonctionnement de cette seconde variante est identique.

## Revendications

1. Dispositif pour amplifier et échantillonner des signaux multiplexés à grande dynamique de manière à leur donner une amplitude optimale avant leur application à un convertisseur analogique-numérique, comportant des moyens d'amplification et d'échantillonnage appliquant à chaque signal multiplexé plusieurs gains d'amplification fixes et différents les uns des autres, des moyens (7) de comparaison de l'amplitude des signaux amplifiés avec des tensions de seuil déterminées ($V_R$) et des moyens (9) pour sélectionner parmi les signaux de gain d'amplification différents, celui dont le gain est optimal, caractérisé en ce que les moyens d'amplification et d'échantillonnage comportent trois ensembles d'amplification et d'échantillonnage (1, 2, 3, 4; 9, 10, 11; $A_1$, $A_2$, $A_3$, 12, 13, 14) dont les gains sont respectivement égaux à 1, $b^4$ et $b^8$ où b est une valeur de gain élémentaire, un amplificateur (5) dont le gain est susceptible de prendre sélectivement les valeurs 1, b, $b^2$ et $b^3$ par action sur des commutateurs de sélection ($I_1$, $I_2$, $I_3$, $I_4$), et des éléments de connexion ($S_1$, $S_2$, $S_3$) pour connecter sélectivement la sortie d'un des trois ensembles d'amplification et d'échantillonnage en série avec l'entrée de l'amplificateur (5), et des moyens de sélection (8) pour choisir une combinaison d'un commutateur de sélection et d'un élément de connexion permettant d'appliquer à chaque signal par un seul cycle d'amplification, un gain compris entre les valeurs 1 et $b^{11}$ susceptible d'amener l'amplitude de chaque signal amplifié à une valeur optimale en relation avec les tensions de seuil déterminées.

2. Dispositif selon la revendication 1, caractérisé en que le premier ensemble d'amplification et d'échantillonnage comporte un premier échantillonneur-bloqueur (1) de gain égal à l'unité, le second comporte un étage d'amplification (2) à gain fixe dont la sortie est connectée à l'entrée d'un second échantillonneur-bloqueur (3), et le troisième comporte un troisième échantillonneur-bloqueur (4) adapté à communiquer un gain d'amplification fixe prédéterminé, qui est connecté également à la sortie dudit étage d'amplification (2).

3. Dispositif selon la revendication 1, caractérisé en ce que le premier ensemble d'amplification et d'échantillonnage comporte un premier échantillonneur-bloqueur (9) de gain égal à l'unité, le second, un second échantillonneur-bloqueur (10) adapté à amplifier avec un gain fixe prédéterminé les signaux qui lui sont appliqués, le troisième, un troisième échantillonneur-bloque (11) adapté également à amplifier avec un gain prédéterminé les signaux qui lui sont appliqués, les trois échantillonneurs-bloqueurs étant connectés en série, la sortie de l'un étant connectée à l'entrée du suivant et leurs sorties étant respectivement reliées aux moyens de connexion ($S_1$, $S_2$, $S_3$).

4. Dispositif selon la revendication 1, caractérisé en ce que chacun de trois ensembles d'amplification et d'échantillonnage comporte un étage d'amplification ($A_3$, $A_4$, $A_5$) à gain fixe prédéterminé et un échantillonneur-bloqueur, les trois étages d'amplification étant interconnectés en série, la sortie de l'un étant connecté à l'entrée du suivant, les trois échantillonneurs-bloqueurs étant respectivement reliés par leurs entrées aux sorties des trois étages d'amplification et par leurs sorties aux moyens de connexion ($S_1$, $S_2$, $S_3$).

5. Dispositif selon l'une des revendications 1 à 4, caractérisé en ce que la valeur de gain élémentaire est choisi égal à deux.

6. Dispositif selon la revendication 5, caractérisé en ce que les gains des étages d'amplification ou des échantillonneurs-bloqueurs sont égaux soit à l'unité, soit au double du gain maximal dudit amplificateur (5).

7. Dispositif selon la revendication 2, caractérisé en ce que le gain de l'étage d'amplification (2) et celui du troisième échantillonneur-bloqueur (4) sont tous les deux égaux au double de gain maximal dudit amplificateur (5).

8. Dispositif selon la revendication 3, caractérisé en ce que les gains du second et du troisième échantillonneur-bloqueur (10, 11) sont tous les deux égaux au double du gain maximal dudit amplificateur (5).

9. Dispositif selon la revendication 4, caractérisé en ce que les gains du second et du troisième étage d'amplificatiion ($A_2$, $A_3$) de la série sont tous les deux égaux au double du gain maximal dudit amplificateur (5).

10. Dispositif selon la revendication 1, caractérisé en ce que les moyens de comparaison (7) comportent des amplificateurs ($A_1$, $A_2$) pour comparer l'amplitude du signal issu de l'amplificateur (5) avec deux tensions de référence ($V_{R+}$, $V_{R-}$).

**Claims**

1. Device for amplifying and sampling high dynamic multiplexed signals so as to give them an optimum amplitude before they are applied to an analog-digital converter, incorporating means of amplification and sampling applying to each multiplexed signal several amplification gains which are fixed and different from each other, means (7) for comparing the amplitude of the amplified signals with voltages of a predetermined threshold ($V_R$) and means (9) for selecting from the different amplification gain signals that one whose gain is optimum, characterised in that the means of amplification and sampling incorporate three amplification and sampling assemblies (1, 2, 3, 4; 9, 10, 11; A1, A2, A3, 12, 13, 14) whose gains are respectively equal to 1, $b^4$ and $b^8$, where b is an elementary gain value, an amplifier (5) whose gain is able to take on selectively the values 1, b, $b^2$, and $b^3$ by acting on the selector switches ($I$, $I_2$, $I_3$, $I_4$), and connection elements ($S_1$, $S_2$, $S_3$) for selectively connecting the output of one of the three amplification and sampling assemblies in series with the input of the amplifier (5), and means of selection (8) for choosing a combination of a selector switch and a connecting element making it possible to apply to each signal, through a single amplification cycle, a gain between the values 1 and $b^{11}$ able to bring the amplitude of each amplified signal to an optimum value with respect to the determined threshold voltages.

2. Device as claimed in claim 1, characterised in that the first amplification and sampling assembly incorporates a first sample and hold unit (1) with a gain equal to unity, the second incorporates an amplification stage (2) with fixed gain whose output is connected to the input of a second sample and hold unit (3) and the third incorporates a third sample and hold unit (4) adapted for communicating a predetermined fixed amplification gain, which is also connected to the output of the said amplification stage (2).

3. Device as claimed in claim 1, characterised in that the first amplification and sampling assembly incorporates a first sample and hold unit (9) with a gain equal to unity, the second, a second sample and hold unit (10) adapted for amplifying with a predetermined fixed gain the signals which are applied to it, the third, a third sample and hold unit (11) also adapted for amplifying with a predetermined gain the signals which are applied to it, the three sample and hold units being connected in series, the output of one being connected to the input of the next and their outputs being connected respectively to the means of connection ($S_1$, $S_2$, $S_3$).

4. Device as claimed in claim 1, characterised in that each of the three amplification and sampling assemblies incorporates an amplification stage ($A_3$, $A_4$, $A_5$, ) with predetermined fixed gain and a sample and hold unit, the three amplification stages being interconnected in series, the output of one being connected to the input of the next, the three sample and hold units being respectively connected by their inputs to the outputs of the three amplification stages and by their outputs to the means of connection ($S_1$, $S_2$, $S_3$).

5. Device as claimed in one of claims 1 to 4, characterised in that the elementary gain value chosen is equal to two.

6. Device as claimed in claim 5, characterised in that the gains of the amplification stages or of the sample and hold units are equal either to unity, or to twice the maximum gain of the said amplifier (5).

7. Device as claimed in claim 2, characterised in that the gain of the amplification stage (2) and that of the third sample and hold unit (4) are both equal to twice the maximum gain of the said amplifier (5).

7

8. Device as claimed in claim 3, characterised in that the gains of the second and third sample and hold units (10, 11) are both equal to twice the maximum gain of the said amplifier (5).

9. Device as claimed in claim 4, characterised in that the gains of the second and third amplification stages ($A_2$, $A_3$) of the series are both equal to twice the maximum gain of the said amplifier (5).

10. Device as claimed in claim 1, characterised in that the means of comparison (7) incorporate amplifiers ($A_1$, $A_2$) for comparing the amplitude of the signal coming from the amplifier (5) with two reference voltages ($V_{R+}$, $V_{R-}$).

**Patentansprüche**

1. Vorrichtung zum Verstärken und Abtasten der Multiplexsignale großer Dynamik, derart, daß man ihnen eine optimale Amplitude vor ihrem Anlegen an einen Analogdigitalwandler verleiht, mit Mitteln zum Verstärken und Abtasten, die an jedes multiplexierte Signal mehrere feste und voneinander verschiedene Verstärkungsgewinne legen, Einrichtungen (7) zum Vergleichen der Amplitude der verstärkten Signale mit bestimmten Schwellenwertspannungen ($V_R$) und Mitteln (9) zum Auswählen desjenigen aus den Signalen unterschiedlichen Verstärkungsgewinns, dessen Verstärkung optimal ist, dadurch gekennzeichnet, daß die Verstärkungs- und Abtastmittel drei Verstärkungs- und Abtastanordnungen (1, 2, 3, 4; 9, 10, 11; $A_1$, $A_2$, $A_3$, 12, 13, 14) umfassen, deren Gewinne jeweils gleich 1, $b^4$ und $b^8$ sind, wo b ein Elementargewinnwert ist, einen Verstärker (5), dessen Gewinn in der Lage ist, selektiv die Werte 1, b, $b^2$, $b^3$ durch Einwirken auf Selektionsumschalter (I, $I_2$, $I_3$, $I_4$) anzunehmen, und Verbindungselementen ($S_1$, $S_2$, $S_3$), um selektiv den Ausgang einer der drei Verstärkungs- und Abtastanordnungen in Reihe mit dem Eingang des Verstärkers (5) zu verbinden, sowie Wählmittel (8), um eine Kombination eines Selektionsumschalters und eines Verbindungselements zu wählen, das es ermöglicht, an jedes Signal durch einen einzigen Verstärkungszyklus einen Verstärkungsgewinn zwischen den Werten 1 und $b^{11}$ zu legen, der in der Lage ist, die Amplitude jedes verstärkten Signals auf einen Optimalwert mit bezug auf die bestimmten Schwellenwertspannungen zu führen.

2. Vorrichtung nach Anspruch 1, dadurch gekennzeichnet, daß die erste Verstärkungs- und Abtastanordnung eine erste Abtast- und Halteschaltung (1) von dem Verstärkungsgewinn gleich der Einheit umfaßt, die zweite eine Verstärkungsstufe (2) mit fester Verstärkung umfaßt, deren Ausgang mit dem Eingang einer zweiten Abtast- und Halteschaltung (3) verbunden ist und die dritte eine dritte Abtast- und Halteschaltung (4) umfaßt, die so ausgelegt ist, daß sie einen festen vorbestimmten Verstärkungsgewinn erteilt, der ebenfalls mit dem Ausgang dieser Verstärkungsstufe (2) verbunden ist.

3. Vorrichtung nach Anspruch 1, dadurch gekennzeichnet, daß die erste Verstärkungs- und Abtastanordnung eine erste Abtast- und Halteschaltung (9) von einem Gewinn gleich der Einheit umfaßt, die zweite eine zweite Abtast- und Halteschaltung (10), die so ausgelegt ist, daß sie mit einem bestimmten festen Gewinn die Signale verstärkt, die an sie gelegt werden, wobei die dritte, eine dritte Abtast- und Halteschaltung (11), so ausgelegt ist, daß sie ebenfalls mit einer vorbestimmten Verstärkung die Signale verstärkt, die an sie gelegt werden, wobei die drei Abtast- und Halteschaltungen in Reihe geschaltet sind und der Ausgang der einen mit dem Eingang der folgenden verbunden ist und ihre Ausgänge jeweils mit den Verbindungsmitteln ($S_1$, $S_2$, $S_3$) verbunden sind.

4. Vorrichtung nach Anspruch 1, dadurch gekennzeichnet, daß jede der drei Abtast- und Halteschaltungen eine Verstärkungsstufe ($A_3$, $A_4$, $A_5$) mit festem vorbestimmtem Verstärkungsgewinn sowie eine Abtast- und Halteschaltung umfaßt, wobei die drei Verstärkungsstufen in Reihe zueinander liegen, wobei der Ausgang der einen mit dem Eingang der folgenden verbunden ist und die drei Abtast- und Halteschaltungen jeweils über ihre Eingänge mit den Ausgängen der drei Verstärkungsstufen und mit ihren Ausgängen mit den Verbindungsmitteln ($S_1$, $S_2$, $S_3$) verbunden sind.

5. Vorrichtung nach einem der Ansprüche 1 bis 4, dadurch gekennzeichnet, daß der Elementarverstärkungsgewinn gleich zwei gewählt ist.

6. Vorrichtung nach Anspruch 5, dadurch gekennzeichnet, daß die Verstärkungsgewinne der Verstärkerstufen oder der Abtast- und Halteschaltungen gleich entweder der Einheit oder dem Doppelten des maximalen Verstärkungsgewinns dieses Verstärkers (5) sind.

7.Vorrichtung nach Anspruch 2, dadurch gekennzeichnet, daß die Verstärkung der Verstärkungsstufe (2) und die der dritten Abtast- und Halteschaltung (4) alle beide gleich dem Doppelten des maximalen Verstärkungsgewinns dieses Verstärkers (5) sind.

8. Vorrichtung nach Anspruch 3, dadurch gekennzeichnet, daß die Verstärkungen der zweiten und dritten Abtast- und Halteschaltungen (10, 11) alle beide gleich dem Doppelten des Maximalgewinns dieses Verstärkers (5) sind.

9. Vorrichtung nach Anspruch 4, dadurch gekennzeichnet, daß die Verstärkungen der zweiten und dritten Verstärkerstufe ($A_2$, $A_3$) der Reihe beide gleich dem Doppelten des Maximalgewinns dieses Verstärkers (5) sind.

10. Vorrichtung nach Anspruch 1, dadurch gekennzeichnet, daß die Vergleichermittel (7) Verstärker ($A_1$, $A_2$) zum Vergleichen der Amplitude des aus dem Verstärker (5) stammenden Signals mit zwei Bezugsspannungen ($V_{R+}$, $V_{R-}$) umfassen.

# FIG.1

EP 0 231 690 B1

# FIG.2

**FIG.3**

**FIG.4**

EP 0 231 690 B1

FIG.5

$\longrightarrow |V_S| < |V_R|$
CP/ =1

$\longrightarrow |V_S| \geq |V_R|$
CP/ =0

EP 0 231 690 B1